# EUROPÄISCHE PATENTANMELDUNG

(11) **EP 3 890 155 A1**
(43) Veröffentlichungstag der Anmeldung: **06.10.2021**
(21) Anmeldenummer: 21163885.3
(22) Anmeldetag: 22.03.2021
(51) Int. Cl.: H02J 7/34, H02M 3/156

(54) **VORRICHTUNG ZUR ENERGIEVERSORGUNG UND VERFAHREN ZUR ENERGIEVERSORGUNG**

(30) Priorität: 31.03.2020 DE 102020108855
(71) Anmelder: Sennheiser electronic GmbH & Co. KG, 30900 Wedemark (DE)
(72) Erfinder: Leschka, Stephan, 14482 Potsdam (DE); Storch, Johannes, 30900 Wedemark (DE)
(74) Vertreter: Eisenführ Speiser

(57) **Zusammenfassung**

Energieversorgungseinheiten z.B. in netzwerkbetriebenen Lautsprechern sind auf Spitzenwerte zugeschnitten, die nur relativ selten und dann impulshaft erreicht werden. Durch eine Zwischenspeicherung von elektrischer Energie auf einem Zwischenkreis-Energiespeicherelement (340) können zumindest kurzzeitig deutlich höhere Leistungen bereitgestellt werden. Das Zwischenkreis-Energiespeicherelement (340) kann z.B. ein Kondensator oder ein Akkumulator sein, der an einer gegenüber der Eingangsspannung (V_{PSE}) erhöhten Zwischenkreisspannung (V_{DCL}) betrieben wird. Die Zwischenkreisspannung (V_{DCL}) wird durch einen Aufwärtswandler (330) erzeugt. Die Ausgangsspannung der Energieversorgungseinheit, die als Versorgungsspannung (Vc) des Audioverstärkers (360) dient, wird durch einen Abwärtswandler (350) aus der im Zwischenkreis-Energiespeicherelement (340) gespeicherten Energie erzeugt. Dabei kann die Energieversorgungseinheit (320) kurzzeitig höhere Stromstärken abgeben als es die eigentliche Energiequelle, z. B. der Netzwerkknoten, könnte. Entsprechend kann das mit der Ausgangsspannung (Vc) der Energieversorgungseinheit (320) betriebene Gerät (360), also z. B. der Audioverstärker, kurzzeitig eine deutlich höhere Effektivleistung (Pₒᵤₜ) aufweisen als bisher üblich.

## Beschreibung

Die Erfindung betrifft eine Vorrichtung zur Energieversorgung, insbesondere aus einer begrenzten Energiequelle. Die Erfindung betrifft ebenfalls einen Lautsprecher mit einer entsprechenden Vorrichtung sowie ein Verfahren zur Energieversorgung, insbesondere zur Energieversorgung aus einer begrenzten Energiequelle.

### Hintergrund

Moderne Geräteanbindung zielt auf die Minimierung der dazu notwendigen Kabelverbindungen ab. Daher wird über Kabel, die ursprünglich nur zur Informationsübertragung dienen, zunehmend auch Versorgungsenergie übertragen. Ein Beispiel ist eine über ein lokales Netzwerk übertragene Gleichspannung zur Energieversorgung angeschlossener Geräte (power over Ethernet, PoE). Dabei versorgt ein Netzwerkknoten (Switch) in einem sternförmigen Netzwerk jedes angeschlossene Netzwerkgerät mit Energie.

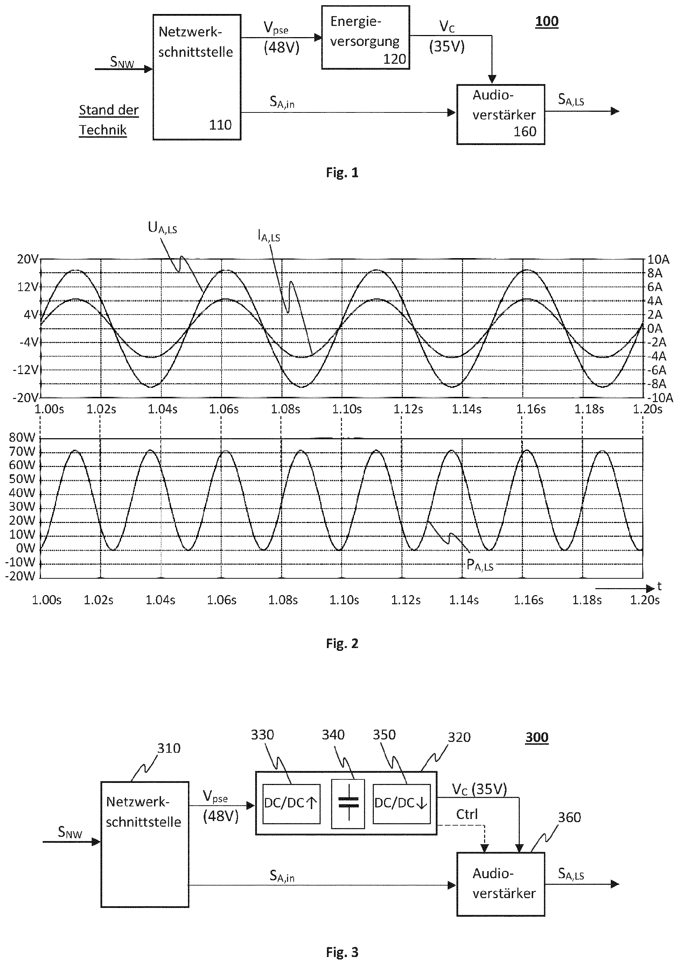

Lautsprecher haben derzeit im Allgemeinen einen Audioeingang und eine separate Energieversorgung. Speziell im Fall des Betriebs an digitalen Audionetzwerken kann die Energieversorgung des Lautsprechers auch über PoE durch den Switch übernommen werden. Ein Vorteil ist, dass bei der Installation lediglich die Verlegung der CAT5/6/x- Netzwerkkabel erforderlich ist, während sich eine separate Spannungsversorgung an jedem Lautsprecher erübrigt. Fig. 1 zeigt ein Blockschaltbild 100 eines Lautsprechers, der mittels PoE an einem Netzwerk betrieben wird. Das Netzwerksignal S_{NW}, das über das Netzwerkkabel empfangen wird, wird in einer Netzwerk-Schnittstelleneinheit 110 in eine Gleichspannung Vₚₛₑ (48V) zur Versorgung und ein wiederzugebendes Audiosignal S_{A,in} aufgespalten. Die Gleichspannung Vₚₛₑ wird in einer Energieversorgungseinheit 120 in eine (meist niedrigere) Spannung umgewandelt, die als Betriebsspannung Vc (z. B. 35V) für einen Audioverstärker 160 dient. Der Audioverstärker 160 verstärkt das wiederzugebende Audiosignal S_{A,in} und erzeugt das Ausgangssignal S_{A,LS}, also das am eigentlichen Lautsprecher bzw. Schallwandler anliegende Audiosignal.

Allerdings ist PoE eine strom- und damit leistungsbegrenzte Energiequelle, die eine Stromstärke von maximal 1.92A liefern kann. Fig. 2 zeigt Spannung, Strom und Leistung eines sinusförmigen (Audio-) Signals an einer resistiven Last. Der Augenblickswert der Leistung P_{A,LS} als Produkt aus Spannung U_{A,LS} und Strom I_{A,LS} schwingt mit doppelter Frequenz um einen zeitlichen Mittelwert. Die Wirkleistung als zeitlicher Mittelwert oder RMS-Leistung entspricht der halben Spitzenleistung. Die Last wird mit der heute üblichen digitalen Endstufe in Vollbrücke häufig über eine unsymmetrische Versorgungsspannung angeschlossen. Dadurch entspricht, bei idealisiertem Wirkungsgrad von 100%, die Spitzenspannung am Tiefpass-gefilterten Endstufenausgang der Versorgungsspannung. Im Falle einer Versorgung durch PoE mit 1.92A/48V steht unter Beachtung der zulässigen Leitungsverluste eine Spitzenleistung von 71W am Endgerät zur Verfügung.

Diese Spitzenleistung wird bei der Speisung eines 4 Ohm-Lastwiderstandes, wie sie ein Lautsprecher typisch darstellt, nach Umsetzung der Betriebsspannung auf 17V mittels zwischengeschaltetem Abwärtswandler voll ausgeschöpft. Die Effektivleistung (root-meansquare- bzw. RMS-Leistung) des Lautsprechers ist damit für einen verzerrungsfreien Betrieb bei Sinussignalen auf 36W begrenzt.

Die Limitierung auf derart geringe elektrische Spitzenleistungen und der damit stark begrenzte maximale Schalldruckpegel stellt z. B. für Studiomonitore ein Problem dar. Es wäre wünschenswert, für netzwerkbetriebene Geräte, insbesondere Lautsprecherboxen, eine höhere Impulsleistung als die so ermittelte Effektivleistung bereitstellen zu können.

Außerdem ist in der Realität die Last oft nicht resistiv, sondern beispielsweise im Fall von Lautsprechern induktiv und dabei frequenzabhängig, so dass sich die Phase der Stromstärke gegenüber der Spannung verschiebt und die tatsächlich umgesetzte Leistung nicht mehr so einfach zu ermitteln ist. Es ist daher eine weitere Aufgabe der Erfindung, eine einfache und trotzdem genaue Messung der umgesetzten Leistung zu ermöglichen.

In der prioritätsbegründenden deutschen Patentanmeldung hat das Deutsche Patent- und Markenamt die folgenden Dokumente recherchiert: US 2007/0236974 A1 und US 2017/0201099 A1.

### Zusammenfassung der Erfindung

Die Aufgabe wird durch eine Vorrichtung gemäß Anspruch 1 gelöst. Der Anspruch 11 betrifft ein erfindungsgemäßes Verfahren.

Die Erfindung beruht auf der Erkenntnis, dass die Dimensionierung der Energieversorgungseinheit, insbesondere bei netzwerkbetriebenen Lautsprechern, auf Spitzenwerte zugeschnitten ist, die nur relativ selten und dann normalerweise impulshaft erreicht werden. Dies kann ebenso für andere Geräte gelten, nicht nur für Audioverstärker bzw. Lautsprecher. Erfindungsgemäß können durch eine Zwischenspeicherung der elektrischen Energie auf einem Zwischenkreis-Energiespeicherelement zumindest kurzzeitig, z. B. impulshaft, deutlich höhere Leistungen bereitgestellt werden. Das Zwischenkreis-Energiespeicherelement kann beispielsweise ein Kondensator oder ein Akkumulator sein, der an einer gegenüber der Eingangsspannung erhöhten Zwischenkreisspannung betrieben wird. Die Ausgangsspannung der Energieversorgungseinheit, die als Versorgungsspannung des Audioverstärkers dient, kann geringer sein als die vom Netzwerk bereitgestellte Versorgungsspannung und wird aus der im Zwischenkreis-Energiespeicherelement gespeicherten Energie erzeugt. Dabei kann die Energieversorgungseinheit kurzzeitig mehr Energie bzw. höhere Stromstärken abgeben als es die eigentliche Energiequelle, z. B. das Netzwerk bzw. der Netzwerkknoten, könnte. Entsprechend kann das mit der Ausgangsspannung der Energieversorgungseinheit betriebene Gerät, also z. B. der Audioverstärker, kurzzeitig eine deutlich höhere Effektivleistung aufweisen als bisher üblich. Anders ausgedrückt kann in einem Gerät wie z.B. einem Lautsprecher eine nur zeitweise erforderliche Impulsleistung zwischengespeichert werden, wodurch der Betrieb an einer Energiequelle mit deutlich geringerer kontinuierlicher Speiseleistung ermöglicht wird. Ein weiterer Vorteil der Erfindung ist, dass eine genaue und sehr einfache Art der Leistungsmessung ermöglicht wird.

Die Zwischenkreisspannung kann beispielsweise etwa das Doppelte oder etwa das Vierfache der Eingangsspannung betragen. Die Zeit, in der die höhere Leistung bereitgestellt wird, kann beispielsweise 100ms-200ms, in anderen Fällen bis zu 800ms betragen.

Weitere vorteilhafte Ausführungsformen werden in den Ansprüchen 2-10 und 12-15 beschrieben.

### Kurze Beschreibung der Zeichnungen

Weitere Einzelheiten und vorteilhafte Ausführungsformen sind in den Zeichnungen dargestellt. Darin zeigt
- Fig. 1: ein Blockschaltbild eines netzwerkbetriebenen Lautsprechers, der mittels PoE betrieben wird;
- Fig. 2: Spannungs-, Strom- und Leistungsverlauf eines sinusförmigen Signals an einem resistiven Verbraucher;
- Fig. 3: ein Blockschaltbild eines erfindungsgemäßen netzwerkbetriebenen Lautsprechers;
- Fig. 4: Spannungs- und Stromverläufe in der erfindungsgemäßen Energieversorgungseinheit sowie die abgegebene Leistung;
- Fig. 5: ein Blockschaltbild einer Energieversorgungseinheit;
- Fig. 6: die frequenzabhängige Impedanz eines Lautsprechers;
- Fig. 7: ein Flussdiagramm eines erfindungsgemäßen Verfahrens;
- Fig. 8: ein Leistungsdiagramm;
- Fig. 9: ein Blockschaltbild einer Energieversorgungseinheit für eine 2-Wegebox in einer ersten Ausführungsform;
- Fig. 10: ein Blockschaltbild einer Energieversorgungseinheit für eine 2-Wegebox in einer zweiten Ausführungsform;
- Fig. 11: ein allgemeines Blockdiagramm eines Audiolimiters;
- Fig. 12: ein Blockdiagramm eines Audiolimiters mit verbesserter Regelung in einer Ausführungsform;
- Fig. 13: simulierte Signalverläufe im Audiolimiter mit verbesserter Regelung und vereinfachter Lastimpedanz;
- Fig. 14: simulierte Signalverläufe im Audiolimiter mit verbesserter Regelung und realistischer Lastimpedanz; und
- Fig. 15: ein Blockschaltbild einer Energieversorgungseinheit für eine 2-Wegebox in einer Ausführungsform.

### Detaillierte Beschreibung der Erfindung

Die Erfindung kann in einer Vielzahl verschiedener Geräte verwendet werden, die ihre Versorgungsspannung aus einer leistungsbegrenzten bzw. strombegrenzten Energiequelle beziehen. Ein Beispiel ist eine verbesserte aktive Lautsprecherbox, die ihre Versorgungsenergie aus einem (Daten-) Netzwerk bezieht, zum Beispiel einem lokalen Netzwerk (LAN gemäß IEEE802.3x oder Ethernet). Dadurch ist keine separate Stromversorgung der Lautsprecherbox nötig. Insbesondere bei Aufbauten mit mehreren Lautsprecherboxen ist es vorteilhaft, dass deshalb weniger Kabel benötigt werden. Im Folgenden sind mit dem Ausdruck "Lautsprecher" i.d.R. die Lautsprecherboxen einschließlich Verstärker gemeint, nicht nur die eigentlichen Schallwandler.

In einer Ausführungsform der Erfindung zeigt Fig. 3 ein Blockschaltbild eines netzwerkbetriebenen Lautsprechers 300. Der Lautsprecher enthält eine Netzwerkschnittstelle 310, über die er ein Netzwerksignal S_{NW} erhält. Dies kann z. B. über die verschiedenen Adern eines Netzwerkkabels erfolgen. Das Netzwerksignal S_{NW} wird aufgespalten in ein Audiosignal S_{A,in} und ein Energieversorgungssignal V_{PSE}. Das Audiosignal wird an einen Audioverstärker 360 weitergeleitet, der mit einer aus dem Energieversorgungssignal V_{PSE} gewonnenen Betriebsspannung Vc betrieben wird. Beispielsweise hat im Falle von PoE das Energieversorgungssignal V_{PSE} eine Spannung von 48V. Anstatt nun, wie üblich, diese Spannung direkt auf die Betriebsspannung Vc von z. B. 35V herunterzusetzen, wird sie in einer Energieversorgungseinheit 320 zunächst auf eine deutlich höhere Zwischenkreisspannung V_{DCL} umgesetzt. Zu diesem Zweck enthält die Energieversorgungseinheit 320 einen Aufwärtswandler 330. Mit der Zwischenkreisspannung V_{DCL} wird ein Energiespeicherelement 340 aufgeladen. Dabei belastet der Aufwärtswandler das Netzwerk nur im zulässigen Rahmen, d. h. die für das Netzwerk zulässigen Werte, insbesondere der Stromstärke und der Leistung, werden eingehalten. Das Energiespeicherelement 340 kann bis auf das Spannungsniveau der Zwischenkreisspannung V_{DCL} geladen werden.

Ein Abwärtswandler 350 transformiert die Zwischenkreisspannung V_{DCL} auf die benötigte Versorgungsspannung Vc herunter. Der Abwärtswandler 350 kann ein Schaltregler sein, z. B. im einfachsten Fall ein bekannter Spannungswandler. Bei Lautsprechern ist es auch möglich, dass die Transformation im Abwärtswandler 350 direkt durch Pulsweitenmodulation (PWM) z. B. über die PWM-Ausgangsstufen erfolgt. In einer Ausführungsform kann der Abwärts-Regler auch eine Potentialtrennung realisieren, um so die hohe Spannung der Energieversorgungseinheit 320 vom Verbraucher bzw. Verstärker 360 fernzuhalten. Der Vollständigkeit halber wird angemerkt, dass der Lautsprecher 300 auch mindestens einen Schallwandler enthält, der hier jedoch nicht dargestellt ist.

Ein Vorteil dieser Anordnung ergibt sich nun daraus, dass die am Ausgang der Energieversorgungseinheit 320 an den Verbraucher bzw. Verstärker 360 abgegebene Energie zumindest ab einer bestimmten Höhe nicht direkt der leistungsbegrenzten Energiequelle, also dem Eingangssignal S_{NW} und damit dem Netzwerk, entnommen wird, sondern dem Energiespeicherelement 340. Der Schwellwert, ab dem Energie aus dem Energiespeicherelement 340 entnommen wird, kann der Energiemenge entsprechen, die dem Netzwerk oder allgemein der leistungsbegrenzten Energiequelle entnehmbar ist, oder darunter liegen. Bei kurzzeitig höherem (d.h. impulsartigem) Energiebedarf wird der Anteil, der über die von der leistungsbegrenzten Energiequelle bereitgestellten Menge hinausgeht, aus dem Energiespeicherelement 340 entnommen, während der leistungsbegrenzten Energiequelle weiterhin nur die zulässige Energiemenge entnommen wird. Im zeitlichen Mittel ist jedoch die an den Verbraucher abgegebene Energiemenge geringer als die Energiemenge, die die leistungsbegrenzte Energiequelle liefern kann. Die Energiedifferenz, d.h. die zusätzlich von derQuelle lieferbare Energie, kann dahergenutzt werden, um das Energiespeicherelement 340 nach einer Entladung sehr schnell wieder aufzuladen.

Da das Energiespeicherelement 340 eine gleichspannungsbasierte Verbindung zwischen der erzeugten (d.h. aufwärts gewandelten) und der abgerufenen Zwischenkreisspannung darstellt, wird es hier auch als DC-Link bezeichnet.

Aus der Spannungsdifferenz zwischen der Ausgangsspannung Vc und der Zwischenkreisspannung V_{DCL} sowie der Kapazität C_{DCL} des Energiespeicherelements 340 definiert sich die in der Energieversorgungseinheit 320 bzw. im Endgerät gespeicherte Energie, und damit die zusätzlich lieferbare Impulsleistung. Der maximale Ausgangsstrom der Energieversorgungseinheit 320 bestimmt gemeinsam mit der aktuellen Ladespannung V_{DCL} die maximal aus der Energieversorgungseinheit 320 entnehmbare Momentanleistung, die deutlich über der der leistungsbegrenzten Energiequelle liegt.

Der Abwärtswandler 350, z. B. ein Schaltregler, entlädt nun bei hoher Impulsleistung das Energiespeicherelement 340. Die Entladung führt zu einer Abnahme der Zwischenkreisspannung V_{DCL} ggf. bis auf das Niveau der benötigten Versorgungsspannung Vc des Endverbrauchers oder, je nach Reglertyp, sogar weiter auf ein noch niedrigeres Spannungsniveau. Dies kann z. B. bei Anwendung eines Inverswandlers, SEPIC oder Buck-/Boost-Reglers an der Ausgangsseite der Fall sein. Optional kann die Energieversorgungseinheit 320 ein Steuersignal Ctrl erzeugen, das weiter unten beschrieben wird.

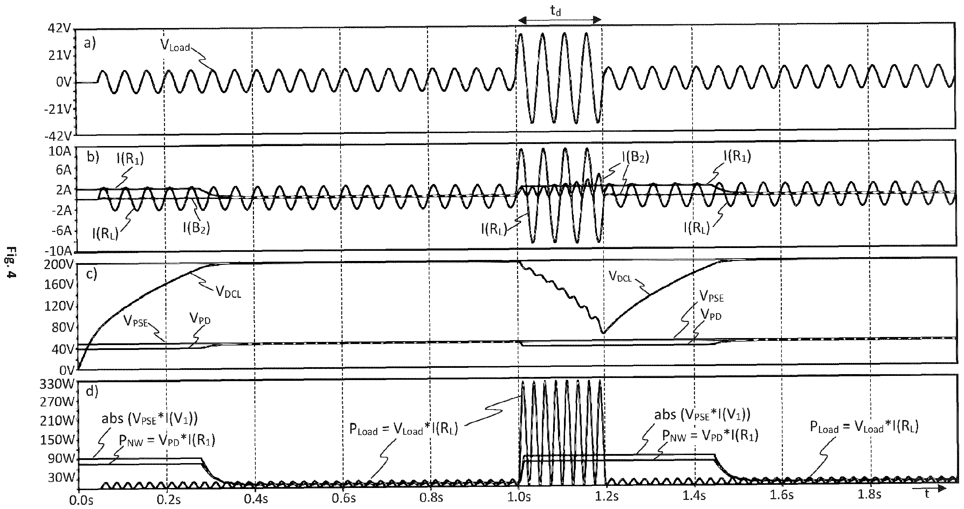

Fig. 4 zeigt Spannungs- und Stromverläufe in der Energieversorgungseinheit 320 sowie die an den Audioverstärker 360 und den daran angeschlossenen Lautsprecher (d.h. Schallwandler) abgegebene Leistung während der Wiedergabe eines Sinussignals. Die Energieversorgungseinheit 320 wird aus einem Netzwerk über PoE mit Energie gespeist. Die Versorgungsspannung V_{PSE} ist konstant 48V. Fig. 4a) zeigt die am Schallwandler anliegende Wechselspannung V_{Load}. Diese liegt zunächst im Bereich ±10V, wechselt aber bei t = 1.0s für eine Dauer von 200 ms auf ±30V, um danach wieder in den ursprünglichen Bereich zurück zu wechseln. Fig. 4b) zeigt den Strom I(R_{L}) durch eine resistive Last, der bei Werten um ±2A ebenfalls dem Sinussignal folgt und ab t = 1.0s für 200 ms auf Werte um ±9A ansteigt. Die abgegebene Leistung P_{Load} = V_{Load} ^{∗} I(R_{L}), die sich daraus ergibt, ist in Fig. 4d) dargestellt; sie bewegt sich zunächst in einem Bereich unter 30W, steigt aber bei t = 1.0s für 200 ms auf einen sehr hohen Wert von ca. 162W (Effektivleistung) bzw. 324W (Spitzenleistung). Somit wird für ein Zeitintervall von t_{d} = 200 ms eine Steigerung der Ausgangsleistung etwa um den Faktor 4.5 bezogen auf die der PoE-Speisung entnommenen Leistung von ca. 71W (zulässige Spitzenleistung) erzielt.

Fig. 4c) zeigt die vom Aufwärtswandler erzeugte, am Energiespeicherelement 340 anliegende Zwischenkreisspannung V_{DCL}, die in den ersten ca. 300 ms bis auf einen Betriebswert von 200V aufgebaut wird. Der zugehörige Ladestrom I(R₁) ist, wie in Fig. 4b) dargestellt, derart begrenzt, dass die zulässige aus dem Netzwerk entnommene Gesamtstromstärke von 1.92A nicht überschritten wird. Optional kann die Geschwindigkeit der Wiederaufladung des Energiespeicherelements 340 dem Ladezustand angepasst werden, indem bei geringer Entladung langsameres Nachladen einstellbar ist. Dabei wird der Ladestrom reduziert, sobald z. B. 90% oder 85% der Betriebsspannung erreicht sind. Dafür kann optional für die letzten 10% bzw. 15% der Ladung der Ladestrom proportional zur Differenz aus maximaler und aktueller Ladespannung des Energiespeicherelements 340 geregelt werden. Dies hat den Vorteil, dass Verluste auf der Zuleitung reduziert werden, da diese quadratisch vom Strom auf der Zuleitung abhängen. Bei t = 1.0s steigt die an den Audioverstärker 360 bzw. den Schallwandler abgegebene Leistung P_{Load} an, wie oben erwähnt. Diese zusätzliche Leistung wird aber nicht der Energiequelle (d. h. dem Netzwerk) direkt entnommen, sondern dem Energiespeicherelement 340. Daher geht die Zwischenkreisspannung V_{DCL} zurück bis auf einen Wert von ca. 60V, der aber immer noch oberhalb der Versorgungsspannung der Quelle von 48V liegt (siehe Fig. 4c)).

Gleichzeitig wird das Energiespeicherelement 340 mit dem in Fig. 4b) dargestellten Ladestrom I(R₁) wieder aufgeladen, wobei aber wieder die zulässige, aus dem Netzwerk entnommene Gesamtstromstärke von 1.92A nicht überschritten wird. Dies kann durch eine Strombegrenzung sichergestellt werden. Entsprechend bricht auch die Versorgungsspannung V_{PSE} nicht zusammen (Fig. 4c), und die aus dem Netzwerk entnommene Leistung P_{NW} bleibt im zulässigen Rahmen bei maximal ca. 71W (Fig. 4d). Insbesondere wird das Netzwerk nicht mit impulshaften Leistungsspitzen belastet.

Das Energiespeicherelement 340 ist in diesem Beispiel so dimensioniert, dass eine Impulsleistung von ca. 162W_{eff} über eine Dauer von ca. 200ms an den Verbraucher abgegeben werden kann, was insbesondere für viele Audioanwendungen ausreicht. Diese Dauer kann durch eine Vergrößerung der Kapazität oder der Zwischenkreisspannung auch weiter erhöht werden. Etwa 500ms nach Beginn (oder ca. 300ms nach dem Ende) dieser Impulsleistung ist das Energiespeicherelement 340 bereits wieder aufgeladen, so dass es erneut eine weitere Impulsleistung z. B. in derselben Höhe liefern könnte. In diesem Beispiel nimmt der Verbraucher während dieser Zeit nur eine sehr geringe oder praktisch keine Leistung auf. Anderenfalls kann das Aufladen länger dauern. Die Energieversorgungseinheit 320 ist entsprechend so auszulegen, dass die besonders hohen impulshaften Lasten nicht zu häufig vorkommen. Bei vorgegebener Spannung und Maximalstromstärke der Energiequelle, wie im Fall von PoE, sind mögliche Parameter für die Dimensionierung der Energieversorgungseinheit 320 z. B. die Ladespannung bzw. Zwischenkreisspannung V_{DCL} und die Kapazität C_{DCL} des Energiespeicherelements 340. Beispielsweise können die genannten zeitlichen Werte mit einer Ladespannung von V_{DCL}=200V und einer Kapazität von C_{DCL}=1000µF erreicht werden. Außerdem kann es für manche Anwendungen ausreichend sein, wenn nur eine Zeitdauer t_{d} von z. B. 100ms oder 150ms überbrückt werden kann.

Wichtig ist dabei, dass die Lade- bzw. Zwischenkreisspannung V_{DCL} deutlich höher ist als die von der Energiequelle erhaltene Versorgungsspannung V_{PSE}, und auch deutlich höher als die an den Verbraucher abgegebene Ausgangsspannung Vc, d. h. V_{DCL} = x₁^{∗}V_{PSE} und V_{DCL} = x₂^{∗}Vc mit x₁,x₂>1. Die Faktoren x₁,x₂ können unterschiedlich oder gleich sein. Vorteilhaft sind Faktoren x₁,x₂ von jeweils mindestens 2, und insbesondere für netzwerkbetriebene Lautsprecher im Bereich x₁,x₂ = 4,...,6 (z. B. x₁=4.2, x₂=5.7, wie im Beispiel). Allgemein kann je nach Anwendung auch ein höherer Faktor vorteilhaft sein. Je höher aber die Zwischenkreisspannung ist, desto höher können auch Verluste in den Spannungswandlern und/oder im Energiespeicherelement 340 sein. Außerdem werden die Bauteile wegen der notwendigen höheren Spannungsfestigkeit teurer. Für die Dimensionierung der Energieversorgungseinheit 320 sind z. B. die erforderliche Impulsleistung und Impulslänge, die Erholungsdauer bzw. Wiederholrate der Impulsleistung und der verfügbare Ladestrom zu berücksichtigen.

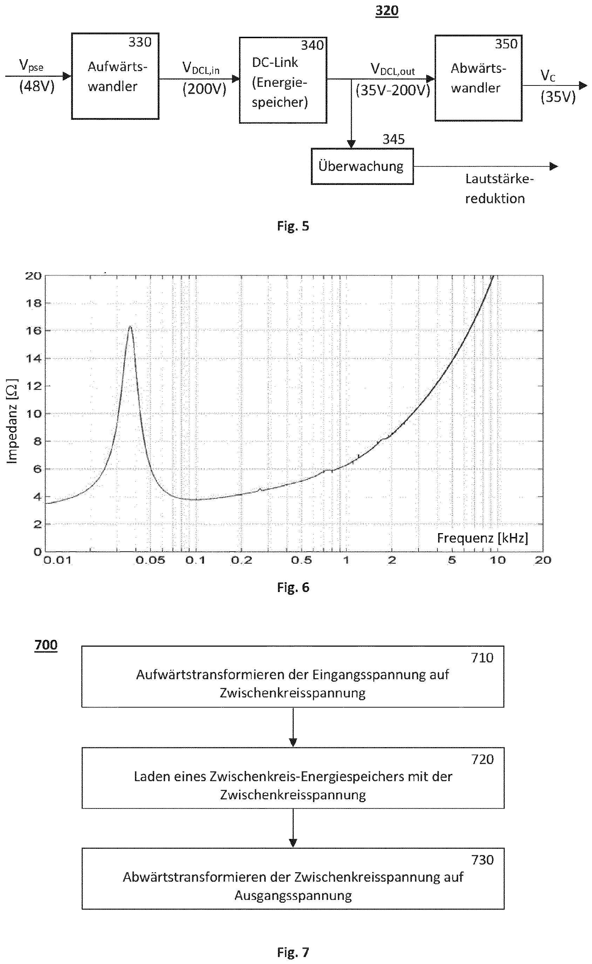

Fig. 5 zeigt in einer Ausführungsform eine Energieversorgungseinheit 320 mit einem Aufwärtswandler 330, einem Energiespeicherelement 340 und einem Abwärtswandler 350. Der Aufwärtswandler 330 erzeugt aus der Versorgungsspannung V_{PSE}=48V die Lade-Zwischenkreisspannung V_{DCL,in}=200V bzw. den nötigen Strom, um das Energiespeicherelement 340 auf diese Spannung aufzuladen. Die vom Energiespeicherelement 340 bereitgestellte Entlade-Zwischenkreisspannung V_{DCL,out} wird vom Abwärtswandler 350 auf die Ausgangsspannung Vc=35V heruntertransformiert. Das Energiespeicherelement 340 kann einen oder mehrere Kondensatoren und/oder Akkumulatoren enthalten. Im einfachsten Fall ist es ein einzelner Kondensator, wobei dann V_{DCL,in} = V_{DCL,out} gelten kann. Der Füllstand des Energiespeicherelements 340 und damit die bereitgestellte Entlade-Zwischenkreisspannung V_{DCL,out} kann schwanken, wie oben beschrieben. Er kann z. B. in einem Bereich von 48V-200V liegen. Je nach Abwärtswandler 350 kann die Entlade-Zwischenkreisspannung V_{DCL,out} auch unter die ursprüngliche Versorgungsspannung fallen und z. B. im Bereich von 35V-200V liegen.

Ein weiterer Vorteil der Erfindung ist, dass eine genaue und sehr einfache Art der Messung des Ist-Wertes der im Lautsprecher umgesetzten Leistung ermöglicht wird. Diese kann dann mit Hilfe eines Begrenzers (Limiter) begrenzt werden. Allerdings wird zur Auslegung klassischer Limiter die Minimalimpedanz des Lautsprechers (d.h. des Wandlers) als konstanter Wert zu Grunde gelegt, um daraus den Limiter-Schwellwert zu berechnen. Dabei wird nicht berücksichtigt, dass die Impedanz des Lautsprechers sich frequenzabhängig ändert: abgesehen vom Impedanzanstieg bei der Resonanzfrequenz (insbesondere wenn der Lautsprecher in ein Gehäuse eingebaut ist, so wie beispielhaft in Fig.6 dargestellt), steigt bei höheren Signalfrequenzen die Impedanz deutlich gegenüber der Minimalimpedanz an, wie in Fig. 6 dargestellt, so dass die im Lautsprecher umgesetzte Leistung stark absinkt. Auch bei (leistungsbedingter) Erhitzung der Schwingspule steigt die Impedanz des Lautsprechers an. Daher werden Limiter üblicherweise auf die Minimalimpedanz ausgelegt und damit restriktiver, als es eigentlich nötig wäre. Beispielsweise würde ein Limiter für einen Lautsprecher, der eine Impedanz wie in Fig. 6 gezeigt aufweist, typischerweise auf die Minimalimpedanz von 4 Ohm (bei etwa 100 Hz) ausgelegt. Mit der Erfindung ist eine verbesserte Auslegung oder Steuerung der Limiter basierend auf der tatsächlich umgesetzten Leistung möglich. Eine alternativ mögliche Ermittlung von Strom und Spannung am Lautsprecher und nachfolgender A/D-Wandlung liefert zwar theoretisch ähnliche Ergebnisse, ist jedoch viel komplizierter zu ermitteln. Außerdem sind die Auslegung und die Kosten der Messelektronik in der Praxis von Nachteil.

In einer Ausführungsform der Erfindung kann die Energieversorgungseinheit 320 nicht nur die erhöhte Impulsleistung liefern, wie oben beschrieben, sondern auch die insgesamt an den Verbraucher abgegebene Energie messen bzw. überwachen. Dazu verfolgt eine Überwachungseinheit 345 z. B. die Zwischenkreisspannung V_{DCL,out} und detektiert damit jede Entnahme von Energie aus dem Energiespeicherelement 340. Durch zeitliche Integration über einen längeren Zeitraum (z.B. eine Sekunde oder eine Minute) kann so die an den Verbraucher abgegebene Energie sehr einfach gemessen werden. Außerdem kann eine übermäßige Energieentnahme detektiert werden, was auf eine Überlastung der Energiequelle und/oder des Verbrauchers hinweist. In diesem Fall kann die Spannungs- bzw. Energieversorgung des Verbrauchers reduziert werden. Insbesondere kann eine Regelung erfolgen derart, dass der Verbraucher im zeitlichen Mittel und abgesehen von den kurzzeitigen Leistungsspitzen nicht mehr Energie aufnimmt als die Energiequelle liefern kann. Es kann auch ein Kontrollsignal Ctrl erzeugt werden, mit dem die übermäßige Energieentnahme angezeigt werden kann, und/oder mit dem der angeschlossene Verbraucher, in diesem Fall der Audioverstärker 360, entsprechend geregelt werden kann, um weniger Energie aufzunehmen. Beispielsweise kann das Kontrollsignal Ctrl benutzt werden, um eine optische Anzeige zu steuern, die dem Nutzer eine Überlastung der Energiequelle anzeigt. Alternativ kann das Kontrollsignal Ctrl auch als (Hardware- oder Software-) Steuersignal für eine Regelung dienen, die das angeschlossene Endgerät so regelt, dass es zumindest für eine bestimmte Zeit weniger Energie aufnimmt als die Energiequelle liefern kann, damit das Energiespeicherelement 340 wieder aufgeladen werden kann, die Last wieder abkühlen kann etc.

Ein weiterer Vorteil der Erfindung ist somit, dass sie eine sehr genaue Messung der in die Last eingespeisten Energie als Funktion der Zeit ermöglicht, zumindest für hohe Werte. Die Energie ist einfach aus dem Spannungsverlauf V_{DCL}(t) des Gleichspannungs-Zwischenkreises ablesbar, wobei alle negativen Energieanteile ΔE (tᵢ₊₁) in die Last eingespeist werden und zu deren Erwärmung beitragen: ΔE (tᵢ₊₁) = ½ C [U²(tᵢ₊₁) - U²(tᵢ)] bzw. ΔP(tᵢ₊₁₎ = ΔE (tᵢ₊₁) / (tᵢ₊₁ - tᵢ)

Beispielsweise ermöglicht diese genaue Kenntnis der in den Lautsprecher eingespeisten Leistung erstmalig eine viel präzisere Einstellung der Limiter bzw. Kompressoren, und damit eine weitere Erhöhung des Schalldrucks bei gleicher Baugröße der Lautsprecher. Basierend auf der eingespeisten Gesamtenergie kann z. B. ein Summenlimiter das Gesamtsystem begrenzen, das mehrere Lautsprecher umfassen kann. Bislang musste die Wirkung der Limiter aus dem Signalspannungsverlauf abgeleitet werden. Da die Lastimpedanz des Lautsprechers aber frequenzabhängig stark schwankt und diese Kurven auch noch temperaturabhängig und auslenkungsabhängig variieren, kann mit dem konventionellen einfachen Verfahren die effektiv in Wärme umgesetzte Wirkleistung nur in sehr grober Näherung ermittelt werden. Basierend auf der erfindungsgemäßen Messung der in den Lautsprecher eingespeisten Leistung kann viel einfacher eine automatische Schutzschaltung gesteuert werden, die den Lautsprecher und/oder Verstärker (oder allgemein den Verbraucher) vor Überlastung schützt.

In einer Ausführungsform betrifft die Erfindung ein Verfahren zur Energieversorgung bzw. Spannungsversorgung einer elektrischen Schaltung aus einer energie- oder strombegrenzten Quelle. Fig. 7 stellt ein entsprechendes Ablaufdiagramm dar. Das von einer Energieversorgungseinheit 320 automatisch ausgeführte Verfahren 700 umfasst die Schritte Aufwärtstransformieren 710 einer Eingangsspannung auf eine Zwischenkreisspannung V_{DCL}, Laden 720 eines Zwischenkreis-Energiespeichers 340 auf die Zwischenkreisspannung V_{DCL}, und Abwärtstransformieren 730 der Zwischenkreisspannung V_{DCL} auf eine Ausgangsspannung. Dabei kann beim Abwärtstransformieren 730 zumindest für eine bestimmte Zeitdauer eine Leistung abgegeben werden, z. B. als Impulsleistung, die über der Leistung des Aufwärtstransformierens 710 innerhalb derselben Zeitdauer liegt. Das Produkt aus Leistung und Zeitdauer ist Energie, so dass mit anderen Worten die Energieversorgungseinheit 320 beim Abwärtstransformieren 730 innerhalb der bestimmten Zeitdauer mehr Energie abgegeben kann als sie gleichzeitig beim Aufwärtstransformieren 710 erhält. Während der bestimmten Zeitdauer wird die zusätzlich abgegebene Energie dem Zwischenkreis-Energiespeicher 340 entnommen. Dieser wird nach Ablauf der bestimmten Zeit wieder aufgeladen. Dabei kann, wie im Beispiel in Fig. 4c) gezeigt, eine weitere Energieentnahme auch schon vor Erreichen der maximalen Zwischenkreisspannung erfolgen. In Fig. 4 wird mit jeder Leistungshalbwelle zwischen t = 1.0s und t = 1.2s die Zwischenkreisspannung V_{DCL} reduziert, woraus sich der treppenförmige Verlauf in Fig. 4c) in diesem Zeitraum ergibt.

Wie oben beschrieben, kann eine übermäßige Energieentnahme detektiert werden. Dies kann erfolgen durch Messen der aktuellen Zwischenkreisspannung V_{DCL} und automatisches Ermitteln einer Energiemenge, die dem Zwischenkreis-Energiespeicher 340 während dessen Entladung entnommen wird, aus der gemessenen aktuellen Zwischenkreisspannung V_{DCL}. Dann wird die ermittelte Energiemenge, oder ein daraus berechneter zeitlicher Mittel- oder Gesamtwert der Energiemenge, mit einem Schwellwert verglichen und ein Steuersignal Ctrl wird automatisch erzeugt, das eine Überschreitung des Schwellwertes anzeigt und/oder genutzt werden kann, um z. B. die Ausgangsspannung zu reduzieren. Der zeitliche Mittel- oder Gesamtwert der Energiemenge wird über eine längere Zeitdauer berechnet, d. h. zumindest länger als ein einzelner maximaler Entladezyklus t_{d}.

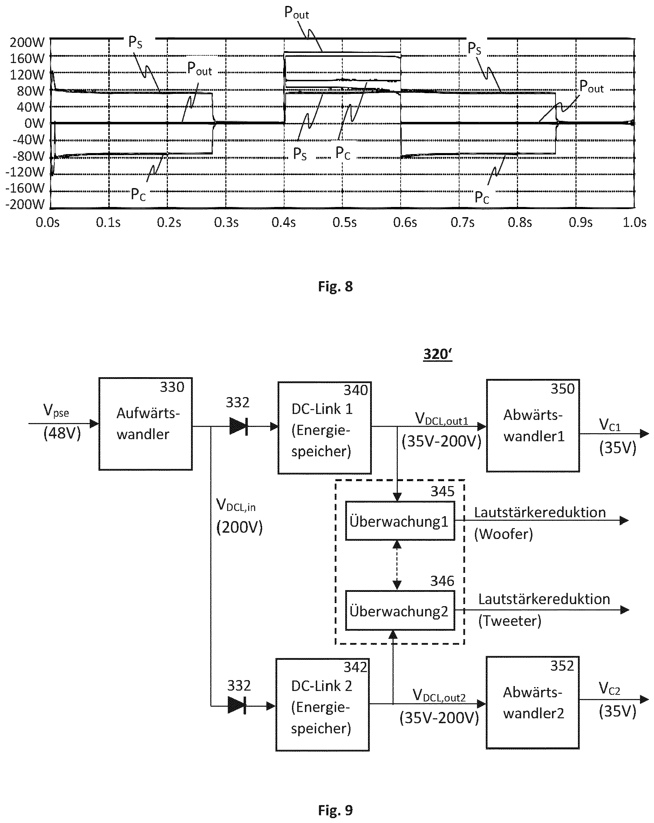

Fig. 8 zeigt die (Effektiv-) Leistungsverläufe innerhalb der Energieversorgungseinheit 320 exemplarisch für eine 200ms andauernde, impulsartige Belastung. Insbesondere werden die Leistung Ps am Ausgang des Aufwärtswandlers 330, die Leistung Pc am Energiespeicherelement 340 und die abgegebene Leistung Pₒᵤₜ dargestellt, wie sie sich in einer Transient-Simulation im Zeitbereich eines Schaltreglers mit interner Schaltfrequenz ergeben. Diese unterscheidet sich von einer vielfach eingesetzten AC-Simulation, bei der die Schaltregler durch linearisierte Elemente (Gain, R, C, L) modelliert sind, da sie realistischer ist. In den ersten ca. 280ms nach dem Einschalten liefert der Aufwärtswandler 330 eine Leistung Ps, die vom Energiespeicherelement 340 aufgenommen wird. Daher ist die Leistung Pc des Energiespeicherelements 340 in diesem Zeitraum negativ. Bei ca. t = 280ms ist das Energiespeicherelement 340 vollgeladen und die Leistung Ps des Aufwärtswandlers 330 geht zurück auf (praktisch) Null, da keine Belastung mehr vorliegt. Auch die Leistung Pc, die das Energiespeicherelement 340 aufnimmt, geht zurück auf Null. Ein angeschlossener Verbraucher benötigt bisher praktisch keine Leistung (Pₒᵤₜ≈0). Bei t = 0.4s beginnt eine 200ms lange Belastungsphase, in der die Leistung Pₒᵤₜ an den Verbraucher abgegeben wird. Dabei wird ein sehr hoher Wert von Pₒᵤₜ =162W erreicht, der sich aus der Summe der vom Aufwärtswandler 330 gelieferten Leistung Ps und der vom Energiespeicherelement 340 gelieferten Leistung Pc zusammensetzt. Beide liefern jeweils ca. 70-90W, wobei die vom Energiespeicherelement 340 gelieferte Leistung Pc sogar höher ist (Pc > Ps). In dem dargestellten Beispiel endet nach 200ms bei t = 0.6s die Belastung durch den Verbraucher im Wesentlichen (Pₒᵤₜ≈0), aber der Aufwärtswandler liefert weiterhin Leistung (Ps > 0), um das Energiespeicherelement 340 wieder aufzuladen (Pc < 0), wie am Anfang. Eine geringe weiterhin vom Verbraucher aufgenommene Leistung kann hierbei ebenfalls vom Aufwärtswandler geliefert werden. Dabei ist es vorteilhaft, dass die vom Aufwärtswandler 330 gelieferte Leistung Ps, die auch der aus der Energiequelle entnommenen Leistung entspricht, nie über einen maximal zulässigen Wert von (in diesem Beispiel) ca. 71W steigt. Wie hier zu erkennen ist, ermöglicht die erfindungsgemäße Lösung zumindest kurzzeitig die Abgabe einer deutlich höheren Leistung als es die Energiequelle könnte, ohne dass die Energiequelle zu stark belastet würde.

Die beschriebene Leistungsmessung kann auch weiter differenziert werden. Beispielsweise können im Fall von Mehrwegeboxen mehrere Gleichspannungs-Zwischenkreise zur Aufteilung der entnommenen Energie herangezogen werden. In Fig. 9 ist, exemplarisch in einer ersten Ausführungsform, ein Blockschaltbild einer solchen Energieversorgungseinheit 320' dargestellt, die mittels PoE eine Zweiwegebox mit Energie versorgt. Hierbei versorgt die vom Aufwärtswandler 330 erzeugte Zwischenkreisspannung V_{DCL,in} zwei getrennte Energiespeicherelemente 340, 342. Deren Ausgänge erzeugen zwei getrennte Zwischenkreisspannungen V_{DCL,out1}, V_{DCL,out2}, mit denen zwei getrennte Abwärtswandler 350, 352 betrieben werden. Somit liefert jedes der Energiespeicherelemente 340, 342 über den jeweiligen Abwärtswandler 350, 352 die Spannungen V_{C1}, V_{C2} jeweils an einen Zweig der Zweiwegebox, entweder an den Tieftöner (Woofer) oder den Hochtöner (Tweeter). Beide Zwischenkreisspannungen V_{DCL,out1}, V_{DCL,out2} können separat überwacht werden, wie oben beschrieben. Das kann in separaten Überwachungseinheiten 345, 346 erfolgen, die jeweils Steuersignale erzeugen können, um die Leistungsaufnahme des jeweiligen Lautsprechers zu reduzieren. Die beiden Überwachungseinheiten 345, 346 können optional zu einer einzigen Einheit zusammengefasst werden und/oder über Signale miteinander kommunizieren, so dass z. B. bei einer Leistungsüberschreitung im Tieftöner nicht nur die Lautstärke des Tieftöners, sondern auch die Lautstärke des Hochtöners reduziert wird. Der Grad der Lautstärkereduktion kann jedoch unterschiedlich sein. Um eine unerwünschte gegenseitige Beeinflussung der beiden gemeinsam versorgten Energiespeicherelemente 340,342 zu verhindern, kann eine entsprechende Schutzschaltung 332 vorgesehen werden, z. B. einfache Dioden.

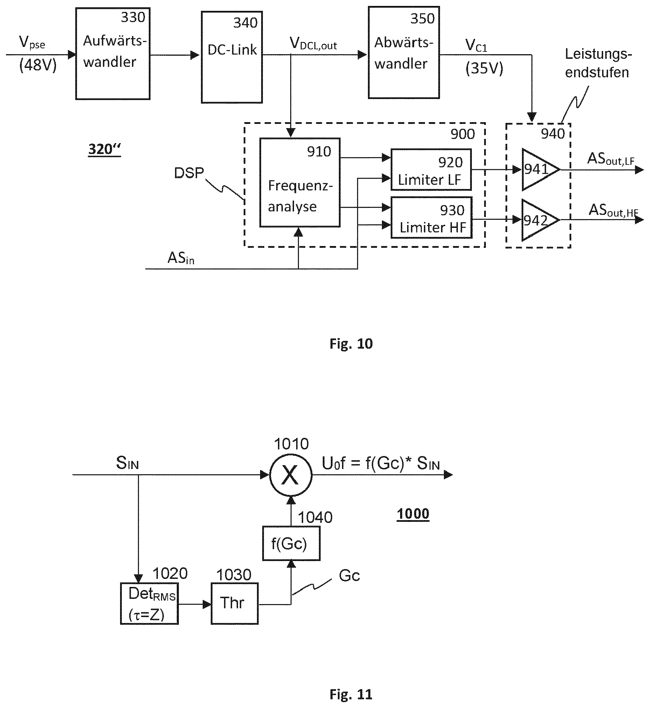

Alternativ ist auch bei Verwendung eines einzelnen Energiespeicherelements 340 die Aufteilung der Energieanteile auf die einzelnen Wandlerwege (z. B. Tweeter, Woofer) möglich. Dies ist vorteilhaft, weil die Energiespeicherelemente (insbesondere für hohe Zwischenkreisspannungen) teuer sind. Fig. 10 zeigt ein Blockschaltbild einer zweiten Ausführungsform einer Energieversorgungseinheit 320" für eine 2-Wegebox. Dabei wird die Zwischenkreisspannung V_{DCL,out} einem Abwärtswandler 350 zugeführt, der sie in diesem Beispiel in eine gemeinsame Versorgungsspannung V_{C1} für eine Leistungsendstufe 940 umwandelt. Die Leistungsendstufe 940 enthält getrennte Verstärkerpfade 941, 942 für tiefe und hohe Frequenzen und erzeugt aus Audiosignalen, die sie von jeweiligen Limitern 920, 930 erhält, die entsprechenden Audiosignale AS_{out,LF}, AS_{out,HF} jeweils für den Tieftöner und den Hochtöner. Die Zwischenkreisspannung V_{DCL,out} wird außerdem einem Frequenzanalyseblock 910 zugeführt, der das wiederzugebende Audioeingangssignal ASᵢₙ analysiert, das auch die Limiter 920, 930 erhalten. Der Frequenzanalyseblock 910 kann daher genau detektieren, welche Leistung insgesamt abgegeben wird und welche Anteile der abgegebenen Leistung jeweils im Hochtöner und im Tieftöner umgesetzt werden. Entsprechend kann er die Limiter 920, 930 separat steuern. Somit kann die vom Energiespeicherelement 340 abgerufene Leistung frequenzabhängig getrennt und den entsprechenden Leistungsendstufen 941, 942 bzw. den Lautsprechern zugeordnet werden.

Fig. 11 zeigt ein allgemeines Blockdiagramm eines bekannten Audio-RMS-Limiters 1000 (analog oder digital) mit einem Signalpfad im oberen Teil und einem Steuerungs- oder Detektorpfad im unteren Teil. Im Detektorpfad läuft das Eingangs-Audiosignal S_{IN} in einen RMS-Detektor 1020 mit eine Zeitkonstante τ=Z. Hier wird der RMS-Wert oder Effektivwert des Audiosignals über eine Zeitdauer Z gebildet, und dieser wird an einen Schwellwertdetektor 1030 weitergeleitet, der es mit einem oder mehreren festgelegten Schwellwert(en) Thr vergleicht. Die Überschreitung des Schwellwertes wird durch ein Signal Gc angezeigt, das eine Verstärkungsfunktion f(Gc) in einem Verstärkungsfaktorgenerator 1040 steuert. Der erzeugte Verstärkungsfaktor f(Gc) wird im Multiplizierer 1010 auf das Eingangs-Audiosignal S_{IN} angewandt. Solange nun der RMS-Wert des Audiosignals über eine Zeitdauer Z unter dem Schwellwert Thr liegt, wird das Audiosignal unverändert an den Ausgang durchgeleitet. Bei Überschreitung des Schwellwertes Thr wird der RMS-Wert des Audiosignals mit einem Verstärkungsfaktor f(Gc)<1 multipliziert und somit reduziert. Im eingeschwungenen Zustand entspricht der RMS-Wert des Ausgangssignals Uof dem Schwellwert Thr. Bei entsprechender Auslegung führt dieses Ausgangssignal zu einer Dauerleistung im Endstufenausgang, die im Lautsprecher zeitlich unbegrenzt umgesetzt werden kann. Die Änderung des Verstärkungsfaktors f(Gc) ist stetig und unterliegt einem definierten zeitlichen Verhalten. Das Steuersignal für den RMS-Detektor 1020 kann dabei nicht nur aus dem Eingangssignal, sondern alternativ auch aus dem Ausgangssignal abgeleitet werden, wobei sich dann die Funktion f(Gc) unterscheidet.

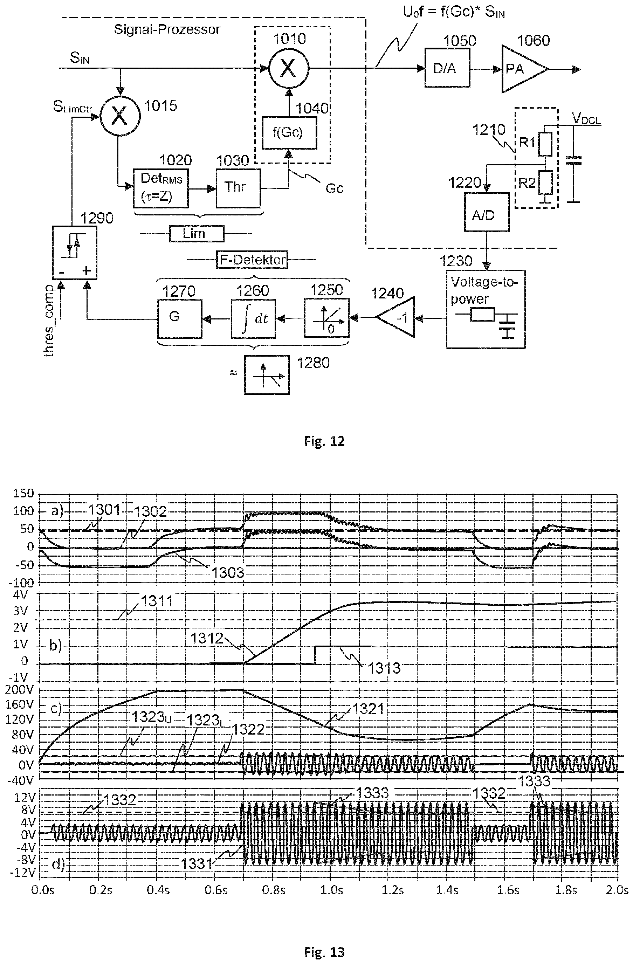

Fig. 12 zeigt ein Blockdiagramm eines Audio-RMS-Limiters mit erfindungsgemäß verbesserter Regelung in einer ersten Ausführungsform. Die verbesserte Regelung basiert auf dem oben beschriebenen DC-Link, der hier nur schematisch als Kondensator angedeutet ist. Insbesondere wird in der oben beschriebenen allgemeinen Form des Audio-RMS-Limiters der Detektor- bzw. Steuerungspfad erweitert, indem der Füllstand des Energiespeicherelements einfließt. Dazu wird ein Steuersignal aus der aktuellen Zwischenkreisspannung V_{DCL} erzeugt, indem diese einen Spannungsteiler 1210 und einen A/D-Wandler 1220 durchläuft. Dadurch steht der aktuelle Ladezustand des Energiespeicherelements bzw. des DC-Link-Kondensators ständig in der digitalen Signalverarbeitung zur Verfügung. Das digitalisierte Steuersignal wird über eine Anpassungsschaltung 1230, 1240, einen zweiten Limiter 1280 mit höherer Integrationszeit sowie einen mit einer Hysterese behafteten Komparator 1290 in ein Limiter-Steuersignal S_{LimCtr} umgewandelt. Dieses wird auf einen Multiplizierer 1015 gegeben, der im Detektorpfad 1020-1040 des Audio-RMS-Limiters eingefügt wurde und der ausschließlich die beiden Zustände 1 oder 0 annimmt, womit der Audio-RMS-Limiter aktiviert oder deaktiviert wird. Das Ausgangssignal Uof des Audio-RMS-Limiters wird über einen D/A-Wandler 1050 und einen Leistungsverstärker 1060 auf Lautsprecher (d.h. Schallwandler) gegeben, wie üblich.

Die Anpassungsschaltung 1230-1240, der zweite Limiter 1280 und sowie der Komparator 1290 stellen einen verbesserten Rückkopplungszweig der Regelung dar. Insbesondere wird aus der aktuellen Zwischenkreisspannung V_{DCL} der Augenblickswert der Lade- bzw. Entladeleistung des Energiespeicherelements 340 kontinuierlich berechnet 1230, invertiert 1240 und dann über eine Tiefpassfunktion 1260 in Verbindung mit einer Verstärkung 1250,1270 geglättet. Die Tiefpassfunktion 1260 kann als Integrator ausgeführt sein, der optional unterschiedliche Zeitkonstanten für Auf- und Abintegration verwendet. Das entstehende Signal wird einem Komparator 1290 zugeführt, der es mit einem Schwellwert thres_comp vergleicht. Bei einer Überschreitung des Schwellwertes wird der Audio-RMS-Limiter aktiviert und die Amplitude des Ausgangssignals Uof reduziert. Die Regelung sorgt jedoch dafür, dass der Audio-RMS-Limiter nicht sofort aktiviert wird, sondern erst nach einer bestimmten Zeit, wie weiter unten beschrieben. Durch die Entkopplung des Zeitverhaltens der DC-Link-Entladung und des Audio-RMS-Limiters wird ein Clipping des Audio-Ausgangssignals trotz der laufenden Regelung unterbunden und somit der Klirrfaktor verbessert. Die Blöcke 1010-1040, 1230-1290 zur digitalen Signalverarbeitung können z. B. durch einen oder mehrere Signalprozessoren implementiert werden.

Fig. 13 zeigt simulierte Signalverläufe im Audiolimiter mit verbesserter Regelung und vereinfachter Lastimpedanz. Der oben beschriebene DC-Link wird hier genutzt, um einen Lautsprecher für 200 ms mit einer (Spitzen-) Leistung von 100W zu versorgen, wobei die aus einem Netzwerk über PoE zur Verfügung stehende Leistung auf 50W begrenzt ist. Dies entspricht hier auch dem Schwellwert Thres_LS des Lautsprechers, da dieser eine Dauerleistung von 50W umsetzen kann. Der Limiter regelt die Audioleistung 1302 innerhalb von 500 ms von 100W auf den Schwellwert 1301 von 50W, wie im oberen Diagramm Fig. 13 a) ersichtlich. Dabei wird anfangs, bis ca. 0.5s nach dem Einschalten, der DC-Link bzw. das Energiespeicherelement 340 geladen, weshalb seine Leistung 1303 negativ dargestellt ist. Die Spannung 1321 des DC-Links (siehe Fig. 13 c)) steigt dabei bis auf ca.200V. Ab t=0.7s wird eine hohe Eingangsspannung 1331 (siehe Fig. 13 d)) auf den Limiter gegeben, so dass die Ausgangsleistung 1302 stark ansteigt und der DC-Link bzw. das Energiespeicherelement Energie abgibt 1303. In Fig. 13 b) sind die simulierten Spannungsverläufe 1312 am Ausgang des Integrators 1260 und 1313 am Ausgang des Komparators 1290 dargestellt. Sobald die Spannung 1312 am Ausgang des Integrators 1260 bei ca. t=0.95s die Schwelle thres_comp 1311 überschreitet, zeigt die Ausgangsspannung 1313 des Komparators 1290 dies an und schaltet damit den Limiter ein. Der DC-Link gibt zu diesem Zeitpunkt bereits seit 0.25s Energie an den Audioverstärker ab, so dass seine Spannung 1321 seitdem fällt. Wie in Fig. 13 d) gezeigt, reduziert der Limiter seine Ausgangsspannung 1333 allmählich innerhalb der nächsten 200 ms, so dass sie dann bei ca. t=1.2s wieder unterhalb der zulässigen Grenze 1332 liegt. Entsprechend wird die Audio-Ausgangsspannung 1322 am Lautsprecher in den zulässigen Bereich innerhalb der Grenzen 1323_{U},1323_{L} zurückgeführt und die Ausgangsleistung 1302 fällt wieder unter den Schwellwert 1301. Somit wird zwar eine kurzzeitige Überlastung des Lautsprechers zugelassen, aber eine Überhitzung wird ebenso wie plötzliche Signalsprünge durch allmähliches Abregeln schon nach kurzer Zeit vermieden.

Da die aus dem Netzwerk entnehmbare Energie vollständig für das Audiosignal gebraucht wird, wird der DC-Link zunächst noch nicht wieder aufgeladen. Erst ab dem Zeitpunkt bei ca. t=1.5s, wenn die Eingangsspannung 1331 wieder unterhalb einer Grenze liegt, wird der Energiespeicher des DC-Links wieder geladen. Dabei ist die gesamte Regelung so eingestellt, dass die Spannung des DC-Links nicht unter 60V fällt. Bei einem nachfolgenden Anstieg der Eingangsspannung 1331 bei ca. t=1.7s ist der DC-Link noch nicht wieder vollständig aufgeladen, so dass die Regelung nun sofort anspringt und die Audio-Ausgangsspannung 1322 auf Werte innerhalb der Grenze 1323_{L},1323_{L} reduziert. Dabei steigt die Ladespannung 1321 des DC-Links zunächst nicht weiter an, da dafür keine Energie "übrig" ist.

In Fig. 13 d) ist zu beachten, dass die Eingangs- und Ausgangsspannung des Limiters weitgehend identisch sind 1331. Abweichungen ergeben sich nur dadurch, dass ab ca. t=1.2s die Ausgangsspannung innerhalb der Grenzen 1333 liegt und daher geringer ist als die Eingangsspannung. Dies ist jedoch wegen der Phasengleichheit (auf Grund der vereinfachten Lastimpedanz) schwierig zu erkennen. Dies betrifft etwa die Zeiträume t=0.95s - 1.5s und t=1.7s - 2.0s.

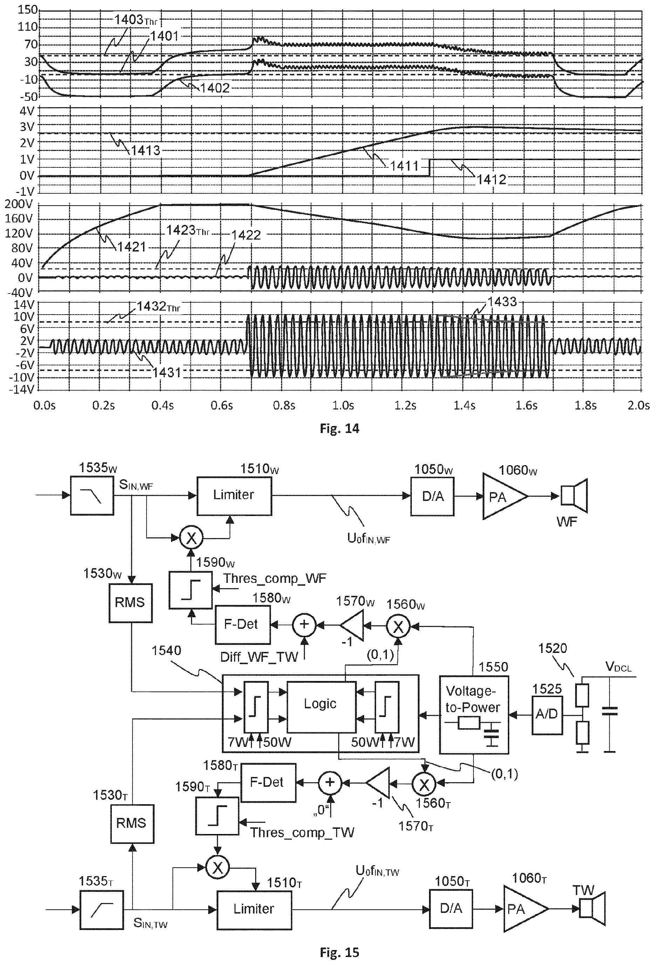

Die Lautsprecherimpedanz wird in Fig. 13 zu einem ohmschen Widerstand von 4 Ohm vereinfacht. Wird nun die Impedanz des Lautsprechers beispielsweise bei einem Betrieb etwas abseits der Minimalimpedanz als Widerstand von 6 Ohm angenommen, so wird der Kondensator des DC-Links weniger entladen. Fig. 14 zeigt simulierte Signalverläufe im Audiolimiter mit verbesserter Regelung und einer solchen realistischen Lastimpedanz von 6 Ohm. Dabei zeigt wieder die obere Kurve 1401 die insgesamt abgegebene Audioleistung gegenüber dem Schwellwert 1403_{Thr}, die zweite Kurve die Spannungsverläufe 1411 am Ausgang des Integrators und 1412 am Ausgang des Komparators, die dritte Kurve 1421 den Ladezustand des DC-Links und die Audiospannung 1422 am Lautsprecher, sowie die vierte Kurve die Eingangs- und Ausgangsspannungen 1431 des Limiters. Die Regelung erfolgt im Prinzip wie oben, aber der Limiter reduziert die Ausgangsleistung erst bei ca. t=1.4s auf 50W, also nach einem Zeitraum von etwa 0.8s mit höherer Leistung. Dabei wird weder der Lautsprecher beschädigt noch das Audiosignal verzerrt. Für den Nutzer ist die Reduktion nicht direkt hörbar, insbesondere werden keine hörbaren Artefakte erzeugt.

Eine Anwendung eines DC-Links ist auch in Mehrwegelautsprechern möglich. Fig. 15 zeigt in einer Ausführungsform ein Blockschaltbild einer Energieversorgungseinheit für einen Zweiwegelautsprecher. Ein Hochpass 1535_{TW} und ein Tiefpass 1535_{WF} werden benutzt, um die Eingangsaudiosignale S_{IN,WF}, S_{IN,TW} für den Tieftöner (Woofer) WF bzw. den Hochtöner (Tweeter) TW zu erzeugen. Die Eingangsaudiosignale S_{IN,WF}, S_{IN,TW} durchlaufen dann jeweilige dynamisch gesteuert Limiter 1510w, 1510_{T}, werden wieder in Analogsignale umgewandelt 1050_{W},1050_{T} und in Leistungsendstufen 1060_{W},1060_{T} verstärkt. Die Blöcke 1560-1590 zur Steuerung der Limiter 1510w, 1510_{T} sind im Prinzip wie oben beschrieben. Es wird angenommen, dass die Entladeleistung des DC-Links 1520 (hier schematisch dargestellt) entweder vom Woofer WF oder vom Tweeter TW entnommen wird. Zu diesem Zweck werden die RMS-Werte beider Einzelpfade separat ermittelt 1530_{T},1530_{W} und mit einem zugehörigen Schwellwert Thres_LS des Audio-Signals verglichen 1540, der in diesem Beispiel bei 7W oder bei 50W liegen kann. Dabei sperrt zunächst die Überschreitung des Schwellwertes in einem der Audiopfade die Aktivierung des Limiters 1510_{W}, 1510_{T} im jeweils anderen Audiopfad. Erst bei gleichzeitiger Überschreitung des "Side-Chain-Limiters" beider Audiopfade und gleichzeitiger Entladung (bzw. unvollständiger Ladung) des DC-Links werden beide Limiter aktiviert. Diese Lösung ermöglicht es, die oben beschriebenen Vorteile für jeden Zweig der Mehrwegebox separat zu erhalten.

Obwohl in den Ausführungsbeispielen Lautsprecherboxen beschrieben werden, die ihre Energieversorgung aus einem (Daten-) Netzwerk (insbesondere LAN gemäß IEEE802.3x bzw. Ethernet) erhalten, ist die Erfindung allgemeiner einsetzbar. Beispielsweise kann die Erfindung zur Energieversorgung beliebiger Geräte aus einer leistungsbegrenzten Energiequelle eingesetzt werden. Die leistungsbegrenzte Energiequelle kann z. B. ein Gerät sein, das seinerseits aus einem Netzwerk mit Energie versorgt wird, so wie z. B. ein an eine Wechselspannung angeschlossenes Netzteil, oder es kann einen Akkumulator enthalten. Auch das Energiespeicherelement 340 kann einen Akkumulator enthalten. Allerdings ist zu beachten, dass im Fall von Audiosignalen entsprechend deren Impulshaftigkeit eine sehr hohe Anzahl der nahezu permanenten Lade- und Entladezyklen zu bewältigen ist, was z. B. für Li-Ion-Akkus nachteilig ist. Außerdem kann die Erfindung vorteilhaft zur genauen Leistungsmessung und/oder zur leistungsabhängigen Regelung eingesetzt werden, was insbesondere für nicht-resistive Verbraucher vorteilhaft ist, da deren Leistungsaufnahme sonst schwierig zu ermitteln ist.

Soweit es sinnvoll und technisch möglich ist, können verschiedene der beschriebenen Ausführungsbeispiele miteinander kombiniert werden.

## Patentansprüche

1. Vorrichtung (320) zur Energieversorgung einer elektrischen Schaltung (360) aus einer Energiequelle, die eine erste Versorgungsspannung (V_{PSE}) liefert, mit
- einem Aufwärtswandler (330) zum Heraufsetzen der ersten Versorgungsspannung (V_{PSE}) auf eine Zwischenkreisspannung (V_{DCL}), die höher ist als die erste Versorgungsspannung;
- einem Energiespeicherelement (340), das vom Aufwärtswandler (330) auf die Zwischenkreisspannung (V_{DCL}) aufgeladen wird; und
- einem Abwärtswandler (350) zum Herabsetzen der Zwischenkreisspannung (V_{DCL}) auf eine zweite Versorgungsspannung (Vc) für die elektrische Schaltung (360);
- wobei der Aufwärtswandler (330) der Energiequelle eine erste Leistung (Ps) entnimmt, und
- wobei der Abwärtswandler (350) zumindest für eine bestimmte maximale Zeitdauer (t_{d}) eine zweite Leistung (P_{Load}, Pₒᵤₜ) an die elektrische Schaltung (360) abgibt, die höher ist als die vom Aufwärtswandler (330) der Energiequelle entnommene erste Leistung (Ps) in derselben Zeit, und
- wobei der Abwärtswandler (350) dem Energiespeicherelement (340) während der bestimmten Zeitdauer (t_{d}) Energie entnimmt, wobei die Zwischenkreisspannung (V_{DCL}) reduziert wird.

2. Vorrichtung nach Anspruch 1, wobei das Energiespeicherelement (340) einen oder mehrere Kondensatoren enthält.

3. Vorrichtung nach Anspruch 1, wobei das Energiespeicherelement (340) einen oder mehrere Akkumulatoren enthält.

4. Vorrichtung nach einem der Ansprüche 1 bis 3, wobei die erste Versorgungsspannung (V_{PSE}) und die zweite Versorgungsspannung (Vc) Gleichspannungen sind.

5. Vorrichtung nach Anspruch 4, wobei die Energiequelle, die die erste Versorgungsspannung (V_{PSE}) liefert, ein Datennetzwerk, insbesondere ein LAN-Netzwerk, oder ein Gerät ist, das an ein solches Netzwerk angeschlossen ist.

6. Vorrichtung nach einem der Ansprüche 4 bis 5, wobei die Zwischenkreisspannung (V_{DCL}) mindestens doppelt so hoch wie die erste Versorgungsspannung (V_{PSE}) ist.

7. Vorrichtung nach Anspruch 6, wobei die Zwischenkreisspannung (V_{DCL}) mindestens viermal so hoch wie die erste Versorgungsspannung (V_{PSE}) und die erste Versorgungsspannung (V_{PSE}) höher als die zweite Versorgungsspannung (Vc) ist.

8. Vorrichtung nach einem der Ansprüche 1 bis 7, wobei die bestimmte maximale Zeitdauer (t_{d}) zwischen 100ms und 200ms liegt und während dieser Zeitdauer die zweite Leistung (P_{Load}, Pₒᵤₜ), die an die elektrische Schaltung (360) abgegeben wird, etwa doppelt so hoch ist wie die erste Leistung (Ps), die der der Energiequelle entnommen wird.

9. Vorrichtung nach einem der Ansprüche 1 bis 8, außerdem mit einer Überwachungseinheit (345), die die aktuelle Zwischenkreisspannung (V_{DCL}) misst, aus der gemessenen aktuellen Zwischenkreisspannung (V_{DCL}) automatisch eine Energiemenge ermittelt, die dem Zwischenkreis-Energiespeicher (340) während der bestimmten Zeitdauer entnommen wird, die ermittelte Energiemenge oder einen daraus berechneten zeitlichen Mittel- oder Gesamtwert der Energiemenge über eine zweite Zeitdauer, die länger als die bestimmte Zeitdauer ist, mit einem Schwellwert vergleicht, und automatisch ein Signal (Ctrl; S_{LimCtr}) erzeugt, das eine Überschreitung des Schwellwertes anzeigt.

10. Lautsprecherbox (300) mit einem Netzwerkanschluss (310), einer Verstärkerschaltung (360) und einer Vorrichtung nach einem der Ansprüche 1-9, wobei die Lautsprecherbox die erste Versorgungsspannung (V_{PSE}) über den Netzwerkanschluss erhalten kann und wobei die elektrische Schaltung (360) die Verstärkerschaltung ist.

11. Verfahren (700) zur Energieversorgung einer elektrischen Schaltung aus einer leistungs- oder strombegrenzten Energiequelle, wobei das Verfahren von einer Energieversorgungseinheit (320) ausgeführt wird und die folgenden Schritte enthält:
- Aufwärtstransformieren (710) einer von der Energiequelle erhaltenen Eingangsspannung (V_{PSE}) auf eine höhere Zwischenkreisspannung (V_{DCL});
- Aufladen (720) eines Zwischenkreis-Energiespeichers (340) auf die Zwischenkreisspannung (V_{DCL}); und
- Abwärtstransformieren (730) der Zwischenkreisspannung (V_{DCL}) auf eine Ausgangsspannung (Vc);
wobei zumindest für eine bestimmte Zeitdauer eine Leistung (P_{Load}, Pₒᵤₜ) an die elektrische Schaltung (360) abgegeben wird, die über einer durch das Aufwärtstransformieren (710) aufgenommenen Leistung (P_{NW}) in derselben Zeit liegt, und wobei während der bestimmten Zeitdauer dem Zwischenkreis-Energiespeicher (340) Energie entnommen und dabei die Zwischenkreisspannung (V_{DCL}) reduziert wird.

12. Verfahren nach Anspruch 11, wobei die erste Versorgungsspannung (V_{PSE}) und die zweite Versorgungsspannung (Vc) Gleichspannungen sind, die Zwischenkreisspannung (V_{DCL}) mindestens doppelt so hoch wie die erste Versorgungsspannung (V_{PSE}) ist und die bestimmte maximale Zeitdauer (t_{d}) mindestens 100ms beträgt.

13. Verfahren nach Anspruch 11 oder 12, zusätzlich mit den Schritten:
- Messen der aktuellen Zwischenkreisspannung (V_{DCL});
- automatisches Ermitteln einer Energiemenge, die dem Zwischenkreis-Energiespeicher (340) während der bestimmten Zeitdauer entnommen wird, aus der gemessenen aktuellen Zwischenkreisspannung (V_{DCL});
- Vergleichen der ermittelten Energiemenge oder eines daraus berechneten zeitlichen Mittel- oder Gesamtwertes der Energiemenge über eine zweite Zeitdauer, die länger als die bestimmte Zeitdauer ist, mit einem Schwellwert; und
- automatisches Erzeugen eines Signals (Ctrl; S_{LimCtr}), das eine Überschreitung des Schwellwertes anzeigt.

14. Verfahren nach Anspruch 13, wobei das Signal (S_{LimCtr}), das eine Überschreitung des Schwellwertes anzeigt, genutzt wird, um automatisch die Energieversorgung der elektrischen Schaltung zu reduzieren.

15. Verfahren nach Anspruch 14, wobei das Signal (S_{LimCtr}) automatisch die Reduktion der Energieversorgung der elektrischen Schaltung zurücknimmt, wenn für eine gegebene Mindestzeit der Schwellwert nicht mehr überschritten wird.
